# EUROPÄISCHE PATENTSCHRIFT

(11) **EP 0 816 529 B1**
(45) Veröffentlichungstag und Bekanntmachung des Hinweises auf die Patenterteilung: **13.06.2001**
(21) Anmeldenummer: 97104908.5
(22) Anmeldetag: 22.03.1997
(51) Int. Cl.: C23C 14/56

(54) **Vakuumbehandelungsanlage zum Aufbringen von Schichten auf Substrate**
Vacuum treatment apparatus for coating of substrates
Appareillage de traitement sous vide pour revêtement de substrats

(30) Priorität: 04.07.1996 DE 19626861
(43) Veröffentlichungstag der Anmeldung: 07.01.1998
(73) Patentinhaber: Unaxis Deutschland Holding GmbH, 63450 Hanau (DE)
(72) Erfinder: Kloberdanz, Hermann, Dr., 63589 Linsengericht-Geislitz (DE); Hoffmann, Josef, 63939 Wörth am Main (DE); Henrich, Jürgen, 63694 Limeshain (DE)

(56) Entgegenhaltungen:
- EP-A- 0 555 764
- DE-A- 2 454 544

## Beschreibung

Die Erfindung betrifft eine Vakuumbehandlungsanlage zum Aufbringen dünner Schichten auf Substrate, beispielsweise auf Scheinwerferreflektoren, mit mehreren, von einer ortsfesten Vakuumkammerwand gehaltenen Behandlungs- und/oder Ein-/Ausschleusstationen und einem von der Vakuumkammerwand umschlossenen, drehbar gelagerten, die Substratkammern tragenden Innenzylinder mit in der Vakuumkammerwand vorgesehenen Öffnungen, mit denen die Substratkammern in Deckung bringbar sind und durch die die Behandlungsmittel auf die Substrate einwirken können und/oder ein- und ausschleusbar sind.

Ein Nachteil bekannter Vorrichtungen liegt in einer aufwendigen Bauweise und oft auch darin, daß sie nur für ganz bestimmtes Beschichtungsgut, beispielsweise für flaches, scheibenförmiges Gut verwendbar sind. Das Aus- und Einschleusen des Beschichtungsgutes ergab oft schwierige Dichtungsprobleme, die durch aufwendige Schleusenkonstruktionen gelöst wurden.

Aus der DE-OS 22 41 634 ist eine Vakuumbeschichtungsanlage der eingangs genannten Art bekannt, bei der die Fördereinrichtung um eine gemeinsame Achse herum angeordnete und um diese schwenkbare topfförmige Rahmen für die Aufnahme des zu beschichtenden Gutes aufweist, wobei in einer Behandlungsposition, nämlich in der Ein- und Ausschleusposition, ein solcher Rahmen selbst Teil der Wand der Ein- und Austrittskammer bildet und eine bewegliche Ventilplatte zum Absperren einer Stirnseite des einen Teils der Ein- und Austrittskammer bildenden Rahmens vorgesehen ist. Bei dieser bekannten Vakuumbeschichtungsanlage ist das Ein- und Ausschleusen des zu beschichtenden Gutes konstruktiv einfach gelöst. Die Weiterbewegung des zu beschichtenden Gutes insbesondere in die Aufdampfposition ist jedoch kompliziert. Der das Gut enthaltende topfförmige Rahmen wird durch Weiterdrehen der Fördereinrichtung in eine Übergabeposition gebracht, aus der die einzelnen Substrate durch eine von unten her angreifende Hubvorrichtung aus dem topfförmigen Rahmen herausgehoben und nach oben in die eigentliche Aufdampfkammer bewegt werden. Hierdurch ergibt sich nicht nur ein erheblicher konstruktiver Aufwand, sondern auch ein komplizierter und zeitraubender Betriebsablauf.

Aus der DE 24 54 544 ist weiterhin eine Vakuumbeschichtungsanlage zum Aufdampfen dünner Schichten auf Substrate bekannt, mit einer Eintrittskammer, weiteren Kammern zur Behandlung bzw. Beschichtung der Substrate und mit einer Austrittskammer, sowie mit einer in einer evakuierbaren Hauptkammer angeordneten Fördereinrichtung zum Transport der Substrate durch die Kammern, wobei Abdichteinrichtungen zur zeitweisen Abdichtung zwischen den genannten Kammern und der Hauptkammer vorgesehen sind und bei der die Fördereinrichtung um eine gemeinsame Achse herum angeordnete und um diese schwenkbare Rahmen für die Aufnahme des zu beschichtenden Gutes aufweist, wobei in wenigstens zwei Behandlungspositionen, nämlich einer Ein- und Austrittsposition und einer Aufdampfposition, ein solcher Rahmen selbst Teil der Wand einer Behandlungskammer, nämlich der Ein- und Austrittskammer und einer Aufdampfkammer bildet, wobei in mindestens einer dieser Behandlungspositionen eine bewegliche Ventilplatte zum Absperren einer Stirnseite des einen Teils der die Behandlungskammer bildenden Rahmens vorgesehen ist.

Bekannt ist auch eine Vorrichtung zum Aufbringen von Schichten auf Trägern unter Vakuum (DE 28 48 480), insbesondere für das abwechselnde Aufbringen von Metallschichten und von Glimmpolymerisationsschichten auf Träger bei der Herstellung von elektrischen Schichtkondensatoren, welche zumindest zwei Vakuumkammern aufweist, die durch Vakuumschleusen voneinander getrennt sind und bei denen in der ersten Vakuumkammer im Betrieb ein kleinerer Restdruck besteht als in der zweiten Kammer oder in den übrigen Kammern, welche eine Transporteinrichtung besitzt, die die zu beschichtenden Träger durch je eine gesonderte Vakuumschleuse von der ersten Vakuumkammer in die zweite Vakuumkammer und wieder in die erste Vakuumkammer oder in eine dritte Vakuumkammer transportieren kann, welche in den Vakuumkammern Einrichtungen zum Aufbringen von Schichten auf die auf der Transporteinrichtung befindlichen Träger enthält und bei welcher die Vakuumschleusen jeweils mehrere Backen, die einer Oberfläche bzw. Oberflächen der Transporteinrichtung unmittelbar gegenüberliegen und zu dieser bzw. diesen nur einen schmalen Spalt freilassen, und jeweils zwischen zwei Backen ein Absaugrohr zur Absaugung des Restgases aufweisen, wobei die Transporteinrichtung nur in einer Richtung bewegbar ist und die in Bewegungsrichtung der Transporteinrichtung vor der ersten Vakuumkammer liegende Vakuumschleuse längere Diffusionswege aufweist als die in Bewegungsrichtung der Transporteinrichtung hinter der ersten Vakuumkammer liegende Vakuumschleuse.

Schließlich ist eine Vakuumbearbeitungsanlage für das Oberflächenbehandeln von Substraten oder Werkstücken bekannt (EP-A-0 555 764), die zylinderartig ausgebildet ist, wobei mindestens eine Aufnahmekammer bzw. ein Behältnis für die Aufnahme der zu bearbeitenden Substrate entlang des Mantels einer kreis- bzw. zylinderförmigen Verteilkammer angeordnet ist, mit peripher nach außen gerichteten Kammeröffnungen, welche in den jeweiligen Bearbeitungspositionen gegen die entsprechenden, im Zylindermantel angeordneten Bearbeitungsstationen gerichtet sind, um die Bearbeitungs- bzw. Prozeßkammern zu bilden, welche Aufnahmekammern bzw. Behältnisse oder der Zylindermantel um die Zylindermittelachse rotierbar angeordnet sind, damit die Aufnahmekammern bzw. Behältnisse relativ zum Zylindermantel bewegbar sind, um von einer Bearbeitungsstation zur nächsten bewegt zu werden, wobei an einem Teil oder allen Aufnahmekammern bzw. Behältnissen und/oder Bearbeitungsstationen pneumatisch oder hydraulisch aktivierbare Dichtungen vorgesehen sind, um beim Bearbeitungsprozeß die Bearbeitungs- bzw. Prozeßkammern dichtend abzutrennen.

Der vorliegenden Erfindung liegt die Aufgabe zugrunde, eine Vorrichtung des in Frage stehenden Typs zu schaffen, bei der eine druckfeste Verbindung zwischen der Ein- und Ausschleusstation einerseits und dem die Substratkammern tragenden Teil oder der jeweiligen Substratkammerwand andererseits herstellbar ist.

Erfindungsgemäß wird diese Aufgabe dadurch gelöst, daß eine der Substratkammern, zumindest aber die Ein-/Ausschleuskammer, einen Deckel oder eine Schleusenklappe aufweist, die den direkten Zugang zur jeweils korrespondierenden Substratkammer gestattet, wobei die Kammer in Richtung auf den Innenzylinder zu verschiebbar und gegen die Außenwand des Zylinders oder die rahmenförmige Stirnfläche der Substratkammer preßbar ist, und wobei die dem Deckel oder der Schleusenklappe zugewandten Fußteile der Wandteile druckfest mit der radial inneren Partie einer rahmenförmigen Flachdichtung aus einem flexiblen Werkstoff verbunden sind, die ihrerseits mit ihrer radial äußeren Partie druckfest mit der Randpartie der Öffnung in der Vakuumkammerwand verbunden sind.

Weitere Einzelheiten und Merkmale sind in den anhängenden Patentansprüchen näher beschrieben und gekennzeichnet.

Die Erfindung läßt die verschiedensten Ausführungsmöglichkeiten zu; eine davon ist in den anhängenden Zeichnungen rein schematisch näher dargestellt, und zwar zeigen:
- Fig. 1: den Schnitt quer durch die Anlage,
- Fig. 2: den rahmenförmigen Teil der Schleusenstationen der Anlage nach Fig. 1, jedoch in vergrößertem Maßstab und im Schnitt,
- Fig. 3: die Dichtelemente der Schleusenstation in der Schließstellung nach Fig. 2 in vergrößertem Maßstab und
- Fig. 4: die Dichtelemente nach Fig. 3, jedoch in der Offen-Stellung.

Die Vorrichtung weist eine Vakuumkammer 7 auf, die mit mehreren, gleichmäßig auf ihrer Außenwand verteilt angeordneten, fensterförmigen Öffnungen 24 bis 27 versehen ist, wobei jeder Öffnung 24 bis 27 eine Behandlungsstation 8,9,10 oder Ein-/Ausschleusstation 20 zugeordnet ist, die jeweils aus einem kastenförmigen, zur jeweiligen Öffnung 24 bis 27 hin offenen, schalenförmigen Gehäuse besteht, dessen umlaufende Randpartie mit der Wand 16,16',... der Vakuumkammer 7 fest verbunden ist. Die Vakuumkammer 7 umschließt einen Innenzylinder 14, der mit Öffnungen 11,12,13,21 versehen ist, die mit den zuvor erwähnten Öffnungen in der Vakuumkammer 7 korrespondieren und in die ebenfalls schalenförmige Substratkammern 3 bis 6 eingesetzt sind, die zusammen mit den Behandlungsstationen 8,9,10 bzw. der Ein-/Ausschleusstation 20 in der in der Zeichnung dargestellten Stellung des Innenzylinders 14 jeweils allseitig geschlossene Behältnisse bilden. Die Vakuumkammerwand ist aus Außenwandteilen 16,16',... gebildet, die jeweils fest mit den Wandteilen der Behandlungsstationen 8,9,10 bzw. der Ein-/Ausschleusstation 20 verbunden sind und so zusammen mit den Kammerwandteilen und dem Innenzylinder 14 Außenkammern 15,15',... bilden. Zwei dieser Außenkammern 15,15',... sind über Bohrungen 17,17' mit den Innenwänden zweier Behandlungsstationen 8,10 verbunden, wobei die Außenwandteile 16',16'' dieser beiden Außenkammern 15',15'' mit Quellen 22 bzw. 23 fest verbunden sind, über die Gase bzw. Monomere über Ausnehmungen 18,18' in die Außenkammern 15' bzw. 15'' einlaßbar sind, so daß beispielsweise in der Behandlungsstation 8 ein Glimmprozeß und in der Station 10 ein Beschichtungsprozeß durchgeführt werden kann. Im Gehäuse der Behandlungsstation 9 sind zwei Sputterkathoden 28,29 untergebracht, wobei die erforderliche Stromversorgung 30 an der Außenwand der Behandlungsstation 9 befestigt ist. Die Außenkammer 15''' steht mit der Schleusenstation 20 über eine Bohrung 32 in Verbindung, die ihrerseits an den Saugstutzen 19 einer nicht näher dargestellten Vakuumpumpe angeschlossen ist. Zum Zwecke des Ein- bzw. Ausschleusens ist der Deckel 33, der das Bodenteil des schalenförmigen Gehäuses bildet, in die strichpunktiert eingezeichnete Stellung verschiebbar. Sämtliche Kammern, nämlich die Behandlungsstationen 8,9,10, die Schleusenkammer 20, die Substratkammern 3 bis 6, die Außenkammern 15,15',.. und der Innenzylinder 14 sind von einer gemeinsamen Bodenplatte 34 und einer nicht dargestellten Deckplatte abgedeckt, so daß sich ein besonders einfacher Aufbau der Vorrichtung ergibt. Der Innenzylinder 14 ist über Arme 35,35',... mit dem Motor 34 drehfest verbunden, damit das aus dem Innenzylinder 14 und den Substratkammern 3 bis 6 bestehende Gebilde innerhalb der eigentlichen, von der Boden-, der Deckplatte und den Außenwandteilen 16,16',... gebildeten Vakuumkammer rotieren kann.

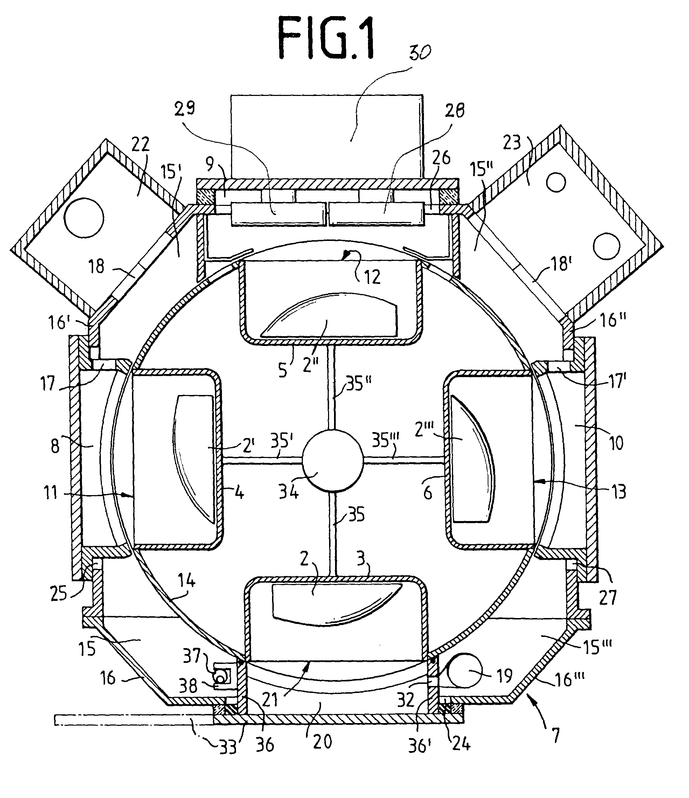

Damit nun die Ein-/Ausschleuskammer 20 durch Verschieben des Deckels 33 in die Offen-Position belüftet werden kann, ohne daß der Druck sich in den übrigen Behandlungskammern 8,9,10 ändert, sind die Seitenwände 36,36',... der Schleusenstation 20 in Pfeilrichtung A um ein geringes Maß verschiebbar gestaltet. Diese Verschiebung der Seitenwände bzw. des rahmenförmigen Teils der Schleusenstation 20 in Richtung auf den Innenzylinder 14 zu bewirkt, daß die Schleusenstation 20 vakuumdicht an der Wand 14 anliegt und so ein Öffnen und Belüften der Station erlaubt, ohne daß sich der Druck in der Vakuumkammer 7 insgesamt ändert. Die Verschiebung der Seitenwände 36,36',... der Station 20 erfolgt über Nockenwellen 37,37',..., die mit Kulissen 38,38',... zusammenwirken, die an den Seitenwänden 36,36',... fest angeordnet sind, (von denen jedoch in Fig. 1 der besseren Übersicht wegen nur eine dargestellt ist).

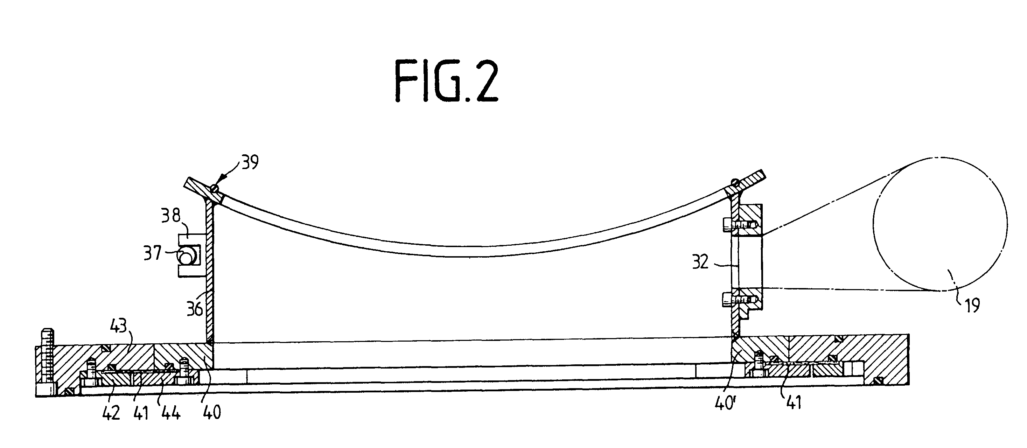

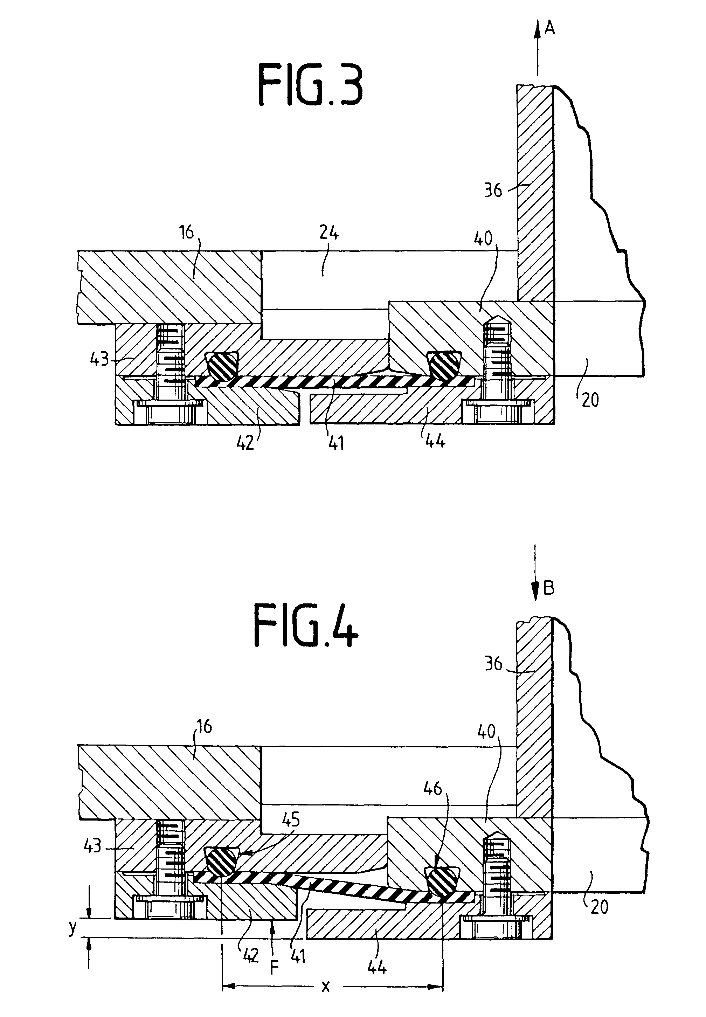

Wie Fig. 2 (vergrößert) zeigt, sind die Seitenwände 36,36',... mit einer rahmenförmige Dichtung 39 versehen, die an die Außenfläche der zylindrischen Wand 14 dichtend anpreßbar ist. Hierzu bewegen sich die Fußteile 40,40',... ebenfalls in Schließ-richtung A (siehe auch Fig. 3 und 4), und zwar aus der in Fig. 4 im Detail dargestellten Ausgangsposition. Um die gewünschte Abdichtung der Seitenfläche 36,36',... gegenüber den Wandteilen 16,16''' der Vakuumkammer 7 zu gewährleisten, sind die Fußteile 40,40',... jeweils fest mit einer rahmenförmigen Flachdichtung 41 verbunden, deren radiale Außenpartien mit einem Rahmen 42 gegen die Wandteile 16,16''' bzw. einen Hilfsrahmen 43 gepreßt werden. Dieser Hilfsrahmen 43 bzw. dessen Außenfläche F bildet die Dichtfläche für die Schleusenklappe bzw. den Deckel 33.

### Bezugszeichenliste

- 2,2': Substrat
- 3: Substratkammer
- 4: Substratkammer
- 5: Substratkammer
- 6: Substratkammer
- 7: Vakuumkammer
- 8: Behandlungsstation
- 9: Behandlungsstation
- 10: Behandlungsstation
- 11: Öffnung
- 12: Öffnung
- 13: Öffnung
- 14: zylindrische Wand, Innenzylinder
- 15,15',...: Außenkammer
- 16,16',...: Außenwand, Vakuumkammerwand
- 17,17',...: Bohrung
- 18,18': Ausnehmung
- 19: Saugstutzen
- 20: Ein-/Ausschleusstation, Schleusenstation
- 21: Öffnung
- 22: Gas-Quelle
- 23: Monomer-Quelle
- 24: Öffnung
- 25: Öffnung
- 26: Öffnung
- 27: Öffnung
- 28: Sputterkathode
- 29: Sputterkathode
- 30: Stromversorgung
- 31: Außenwand
- 32: Bohrung
- 33: Deckel, Schleusenklappe
- 34: Motor
- 35,35' , ...: Arm
- 36,36',...: Seitenwand
- 37,37',...: Nockenwelle
- 38,38',...: Kulisse
- 39: Dichtung
- 40,40',...: Fußteil
- 41: Flachdichtung
- 42: Rahmen, Klemmrahmen
- 43: Hilfsrahmen
- 44,44',...: Klemmleiste
- 45: Dichtring
- 46: Dichtring

## Patentansprüche

1. Vakuumbehandlungsanlage zum Aufbringen dünner Schichten auf Substrate (2,2',...), beispielsweise auf Scheinwerferreflektoren, mit mehreren, von einer ortsfesten Vakuumkammerwand (16,16',...) gehaltenen Behandlungs-(8,9,10) und/oder Ein-/Ausschleusstationen (20) und einem von der Vakuumkammerwand umschlossenen, drehbar gelagerten, die Substratkammern (3 bis 6) tragenden Gestell oder Innenzylinder (14), wobei in der Vakuumkammerwand (16,16',...) Öffnungen (24 bis 27) vorgesehen sind, mit denen die Substratkammern (3 bis 6) in Deckung bringbar sind und durch die die Behandlungsmittel auf die Substrate (2,2',...) einwirken können und/oder ein- und ausschleusbar sind, wobei eine der Substratkammern, zumindest aber die Ein-/Ausschleuskammer (20) einen Deckel oder eine Schleusenklappe (33) aufweist, die den direkten Zugang zur jeweils korrespondierenden Substratkammer gestattet, und wobei die Kammer (20) in Richtung auf den Innenzylinder (14) zu verschiebbar (A,B) und gegen die Außenwand des Zylinders (14) oder die rahmenförmige Stirnfläche der Substratkammer (3) preßbar ist und die dem Deckel (33) zugewandten Fußteile (40,40',...) der Wandteile (36,36',...) der Kammer (20) druckfest mit der radial inneren Partie einer rahmenförmigen Flachdichtung (41) aus einem flexiblen Werkstoff verbunden sind, wobei die Flachdichtung (41) ihrerseits mit ihrer radial äußeren Partie druckfest mit dem Randbereich der Öffnung (24) in der Vakuumkammerwand (16,16''') verbunden ist.

2. Vakuumbehandlungsanlage nach Anspruch 1, **dadurch gekennzeichnet,** daß die rahmenförmige Flachdichtung (41) einerseits mit ihrer radial äußeren Randpartie zwischen dem Fußteil der Seitenwand (36,36',...) und einer Klemmleiste (44,44',...) und andererseits mit ihrer radial inneren Partie zwischen der Vakuumkammerwand (16, 16', ...) oder einem Hilfsrahmen (43) und einem Klemmrahmen (42) oder Klemmstücken eingespannt ist, wobei der Abstand (x) der einander parallelen Einspannstellen voneinander etwa dem zwölffachen des maximalen Verschiebewegs (y) der Seitenwand (36,36',...) gegenüber der Vakuumkammerwand (16,16''') beträgt.

3. Vakuumbehandlungsanlage nach den Ansprüchen 1 und 2, **dadurch gekennzeichnet,** daß die rahmenförmige Flachdichtung (41) vakuumkammerseitig jeweils an Dichtwülsten oder Dichtringen (45 bzw. 46) anliegt, die ihrerseits in Nuten gehalten sind, die in das Fußteil (40) und den Hilfsrahmen (43) oder die Vakuumkammerwand (16,16''') eingeschnitten sind.

4. Vakuumbehandlungsanlage nach den Ansprüchen 1 und 2, **dadurch gekennzeichnet,** daß die der Flachdichtung (41) zugekehrten Flächen des Fußteils (40) und des Hilfsrahmens (43) oder der Vakuumkammerwand (16,16''') so bemessen und ausgeformt sind, daß sie zusammen eine zusammenhängende Stütz- oder Anlagefläche für die Flachdichtung (41) bilden.

## Claims

1. Vacuum treatment system for the application of thin layers to substrates (2, 2', ...) for example to headlight reflectors, with several treatment stations (8, 9, 10) and or intake/discharge air-lock stations (20) held by a fixed vacuum chamber wall (16, 16', ...) and a stand or inner cylinder (14), mounted so that it can rotate, supporting the substrate chambers (3 to 6), surrounded by the vacuum chamber wall, having apertures (24 to 27) provided in the vacuum chamber wall (16, 16', ...) with which the substrate chambers (3 to 6) can be brought into contact and through which the treatment agents can act on the substrates (2, 2', ...) and/or can be brought in or out through the air-lock, whereby one of the substrate chambers, but at least the intake/discharge air lock chamber (20) has a cover or an air lock flap (33), which permits direct access to the respective corresponding substrate chamber and whereby the chamber (20) can be slid in the direction of the inner cylinder (14) (A, B) and pressed against the outer wall of the cylinder (14) or against the frame-shaped face surface of the substrate chamber (3) and the foot areas (40, 40', ...) turned towards the cover (33) of the wall sections (36, 36', ...) of the chamber (20) are connected in a pressure-tight manner with the radially inner part of a frame-shaped flat seal (41), made of a flexible material, the flat seal (41) for its part being connected in a pressure-tight manner via its radially outer part to the edge area of the aperture (24) in the vacuum chamber wall (16, 16''').

2. Vacuum treatment system according to claim 1, characterised in that the frame shaped flat seal (41) is constrained firstly via its radially outer edge part between the foot area of the side wall (36, 36', ...) and a clamping strip (44, 44', ...) and secondly via its radially inner part between the vacuum chamber wall (16, 16', ...) or an auxiliary frame (43) and a clamping frame (42) or clamping pieces, the distance (x) between the constraining points, parallel to each other, amounting to approximately twelve times the maximum slide path (y) of the side wall (36, 36', ...) in respect of the vacuum chamber wall.

3. Vacuum treatment system according to claims 1 and 2, characterised in that the frame-shaped flat seal (41) on the vacuum chamber side is in contact with sealing beads or gaskets (45 and/or 46), which in turn are held in grooves, which are cut into the foot area (40) and into the auxiliary frame (43) or the vacuum chamber wall (16, 16''').

4. Vacuum treatment system according to claims 1 and 2 characterised in that the surfaces of the foot area (40) and the auxiliary frame (43) or the vacuum chamber wall (16, 16''') turned towards the flat seal (41) are dimensioned and shaped in such a way that together they form a continuous supporting or contact surface for the flat seal (41).

## Revendications

1. Installation de traitement sous vide, pour l'application de couches minces sur des substrats (2, 2',...), par exemple sur des réflecteurs de phares, comprenant plusieurs stations de traitement (8, 9, 10) et/ou plusieurs stations d'entrée/sortie (20) contenues par une paroi de chambre à vide (16, 16',...) stationnaire, et un châssis ou cylindre intérieur (14) monté en rotation, enfermé par la paroi de chambre à vide et portant les chambres à substrats (3 à 6), dans laquelle des ouvertures (24 à 27) sont ménagées dans la paroi de chambre à vide (16, 16',...), avec lesquelles les chambres à substrats (3 à 6) peuvent être amenées en concordance, et à travers lesquelles les produits de traitement peuvent agir sur les substrats (2, 2',...) et/ou lesdits produits peuvent être introduits et/ou sortis, l'une des chambres à substrats et tout au moins la chambre d'entrée/sortie (20) comporte un couvercle ou un clapet de sas (33) qui permet l'accès direct à la chambre à substrat respective correspondante, et la chambre (20) est susceptible d'être déplacée (A, B) en direction du cylindre intérieur (14) est d'être pressée contre la paroi extérieure du cylindre (14), ou contre la surface frontale en forme de cadre de la chambre à substrat (3), et les parties de pied (40, 40',...), tournées vers le couvercle (33), des parties de paroi (36, 36',...) de la chambre (20) sont reliées de manière résistante à la pression avec la partie intérieure radiale d'un joint plat en forme de cadre (41) en matériau souple, ledit joint plat (41) étant relié de son côté de manière résistante à la pression, de par sa partie radiale extérieure, avec la région de bordure de l'ouverture (24) dans la paroi de chambre à vide (16, 16''').

2. Installation de traitement sous vide selon la revendication 1, caractérisée en ce que le joint plat (41) en forme de cadre est serré d'une part au moyen de sa partie de bordure radiale extérieure entre la partie de pied de la paroi latérale (36, 36',...) et une baguette de serrage (44, 44',...), et d'autre part au moyen de sa partie radiale intérieure entre la paroi de chambre à vide (16, 16',...) ou un cadre auxiliaire (43) et un cadre de serrage (42) ou des pièces de serrage, de sorte que la distance (x) des emplacements de serrage mutuellement parallèles l'un par rapport à l'autre s'élève approximativement à 12 fois le trajet de déplacement maximum (y) de la paroi latérale (36, 36',...) par rapport à la paroi de chambre à vide (16, 16"').

3. Installation de traitement sous vide selon les revendications 1 et 2, caractérisée en ce que le joint plat (41) est appliqué, du côté de la chambre à vide, sur des bourrelets d'étanchement ou sur des anneaux d'étanchement (45 ; 46) respectifs, qui sont maintenus de leur côté dans des gorges taillées dans la partie de pied (40) et dans le cadre auxiliaire (43) ou dans la paroi de chambre à vide (16, 16"').

4. Installation de traitement sous vide selon les revendications 1 et 2, caractérisée en ce que les surfaces, tournées vers le joint plat (41), de la partie de pied (40) et du cadre auxiliaire (43) ou de la paroi de chambre à vide (16, 16"'), sont choisies de telles dimensions et de telles conformations qu'elles forment ensemble une surface de soutien ou d'appui continue pour le joint plat (41).
